**Europäisches Patentamt**

**European Patent Office**

**Office européen des brevets**

(19)

(11) Veröffentlichungsnummer: **0 417 037 A2**

## (12) EUROPÄISCHE PATENTANMELDUNG

(21) Anmeldenummer: **90810640.4**

(22) Anmeldetag: **23.08.90**

(51) Int. Cl.5: **C23C 18/20, C23C 18/42**

(30) Priorität: **01.09.89 CH 3172/89**

(43) Veröffentlichungstag der Anmeldung:
**13.03.91 Patentblatt 91/11**

(84) Benannte Vertragsstaaten:
**BE CH DE ES FR GB IT LI NL SE**

(71) Anmelder: **CIBA-GEIGY AG**
**Klybeckstrasse 141**
**CH-4002 Basel(CH)**

(72) Erfinder: **Cassat, Robert**
**Chemin de Crapon**
**F-69360 Ternay(FR)**
Erfinder: **Logel, Jean-Pierre**
**Boulevard de l'Europe 19**
**F-68100 Mulhouse(FR)**

(54) **Verfahren zum Beschichten von Kunststoff-Gegenständen.**

(57) Verfahren zum Beschichten eines Kunststoff-Gegenstandes mit einer dünnen Edelmetallschicht, dadurch gekennzeichnet, dass der Kunststoff-Gegenstand einen feinteiligen, homogen verteilten Füllstoff ausgewählt aus der Gruppe bestehend aus MnO, NiO, $Cu_2O$, SnO und $Bi_2O_3$ enthält und dieser Kunststoff-Gegenstand mit einer sauren wässrigen Lösung eines Edelmetallsalzes behandelt wird.

EP 0 417 037 A2

## VERFAHREN ZUM BESCHICHTEN VON KUNSTSTOFF-GEGENSTÄNDEN

Die vorliegende Erfindung betrifft ein Verfahren zum Beschichten von Kunststoff-Gegenständen mit einer dünnen Edelmetallschicht, sowie die so erhältlichen beschichteten Kunststoff-Gegenstände.

In verschiedenen Industriezweigen spielt die Metallisierung von Kunststoff-Oberflächen eine zunehmend wichtige Rolle. Die elektrisch leitende Beschichtung von elektrisch isolierenden Substraten ist vor allem in der elektronischen Industrie, z.B. bei der Herstellung gedruckter Schaltungen, von Bedeutung. Aber auch bei der Herstellung dekorativer und/oder reflektierender Gegenstände kommen metallisierte Kunststoff-Teile zur Anwendung.

Die übliche Methode, Kunststoffe zu metallisieren ist die elektrochemische Abscheidung von Metallen auf Kunststoffoberflächen. Dabei wird in einem ersten Schritt die Kunststoffoberfläche chemisch oder mechanisch vorbehandelt, in einem zweiten Schritt ein diskontinuierlicher Metall-Primer aufgebracht, in einem dritten Schritt wird durch ein chemisches Verstärkungsbad, enthaltend ein Metallsalz und ein Reduktionsmittel, eine sehr dünne kontinuierliche metallische Schicht aufgebracht, und schlussendlich wird das so vorbehandelte Substrat zur galvanischen Metallisierung in eine wässrige Lösung eines Metallsalzes gegeben, um so eine dickere Schicht des Metalles zu erhalten. Die Primer-Beschichtung wird z.B. aufgebracht, indem man das vorbehandelte Substrat in eine saure Zinnsalz-Lösung gibt und den Gegenstand anschliessend in eine wässrige Edelmetallösung metallisiert. Beide Bäder können auch kombiniert werden.

Diese Methode ist ziemlich kompliziert und hat viele Einzelschritte, die sich durch heikle Prozessbedingungen auszeichnen. Während die chemische bzw. mechanische Vorbehandlung oft zur Beschädigung des Substrats führt, treten bei dem Aufbringen des Metall-Primers häufig Probleme wegen mangelnder Benetzbarkeit der Kunststoff-Oberfläche durch die Primer-Lösung auf. Die so erzeugte Primer-Schicht ist von schlechter Qualität, diskontinuierlich und schlecht haftend. Dieses und andere spezielle Metallisierungsverfahren sind in der US 4,590,115 beschrieben.

Es bestand daher das Bedürfnis, ein Metallisierungsverfahren zu finden, welches möglichst einfach durchzuführen ist, welches kontinuierliche Metallbeschichtungen liefert und welches eine verbesserte Haftung der Metallschicht auf der Kunststoff-Oberfläche mit sich bringt.

Die vorliegende Erfindung betrifft ein Verfahren zum Beschichten eines Kunststoff-Gegenstandes mit einer dünnen Edelmetallschicht, dadurch gekennzeichnet, dass der Kunststoff-Gegenstand einen feinteiligen, homogen verteilten Füllstoff ausgewählt aus der Gruppe bestehend aus MnO, NiO, $Cu_2O$, SnO und $Bi_2O_3$ enthält und dieser Kunststoff-Gegenstand mit einer sauren wässrigen Lösung eines Edelmetallsalzes behandelt wird.

Der zu beschichtende Kunststoffgegenstand besteht z.B. aus 2,5-90 Gew.-%, vorzugsweise 10-30 Gew.-%, der genannten Metalloxide und 97,5-10 Gew.-%, vorzugsweise 90-70 Gew.-%, eines polymeren Harzes.

Als polymere Harze eignen sich prinzipiell alle Thermoplasten, hitzehärtbaren Harze und Elastomeren und Gemische dieser Harze.

Einzelheiten und Erklärungen über die zu verwendenden polymeren Harze können der US 4,590,115 entnommen werden. Das dort Erwähnte hat auch für die vorliegende Erfindung Gültigkeit.

Bevorzugt kommen die folgenden Harze zum Einsatz: Epoxid-, Acrylatharze, Polyimide, Polyamide, Polyester, Polyurethane, Polyacetale, Polycarbonate, Melaminharze, Polytetrafluorethylen, Polyvinylfluoride, Polyethylen, Polypropylen, ABS, Polyphenylensulfid, Polyetherimide, Polyarylenetherketone, PVC, Melamin-Formaldehydharze und Phenolharze.

Von den Metalloxiden ist $Cu_2O$ bevorzugt.

Die Einarbeitung der Metalloxide in das Harz erfolgt nach bekannten Methoden. Einzelheiten darüber können wiederum der US 4,590,115 entnommen werden. Für die Gewährleistung gleichmässiger kontinuierlicher Edelmetallschichten ist es wichtig, dass das Metalloxid im polymeren Substrat homogen verteilt ist. Grundsätzlich sind die mit solchen Metalloxiden gefüllten polymeren Substrate bekannt und z.B. in der US 3,146,125 und der US 4,590,115 beschrieben.

Während die Metalloxide in den Kunststoffgegenständen der US 3,146,125 mit Säuren partiell reduziert werden, erfolgt die Reduktion in der US 4,590,115 vollständig durch Einwirkung von Borhydriden. Die letztgenannte Methode ist relativ heikel, weil das Reduktionsmittel nur in einer dünnen Schicht auf der zu metallisierenden Oberfläche eingesetzt werden kann. Das Eintauchen in ein reduzierendes Bad ist dabei nicht möglich, da die Redoxpartner in die Lösung diffundieren und damit das entstehende Metall für die Beschichtung verloren geht und das Borhydridbad dadurch schnell altert.

Es wurde beim erfindungsgemässen Verfahren überraschenderweise festgestellt, dass die sich bildenden Edelmetallteilchen an der Oberfläche des zu metallisierenden Kunststoff-Gegenstandes gut haften und der Verlust an diesen Metallen durch Abscheiden im Bad äussert gering ist.

Erfindungsgemäss eignen sich besonders wässrige Lösungen, welche mindestens $10^{-5}$ Mol/l eines Edelmetallsalzes enthalten; die obere Grenze ist unkritisch und wird allein durch die Löslichkeit der Edelmetallsalze bestimmt. Der bevorzugte Konzentrationsbereich liegt zwischen 0,0005 und 0,005 Mol/l. Die dabei enstehenden Edelmetallschichten haben eine typische Dicke von $\leq 1$ $\mu$m und sind kontinuierlich.

Als Edelmetallsalze eignen sich besonders Salze von Au, Ag, Ru, Rh, Pd, Os, Ir oder Pt.

Als Anionen sind beliebige Anionen geeignet, solange die so gebildeten Salze in einer sauren wässrigen Lösung in den oben angegebenen Konzentrationen löslich sind.

Geeignete Salze sind z.B. $AuBr_3$ ($HAuBr_4$), $AuCl_3$ ($HAuCl_4$) oder $Au_2Cl_6$, Silberacetat, Silberbenzoat, $AgBrO_3$, $AgClO_4$, AgOCN, $AgNO_3$, $Ag_2SO_4$, $RuCl_4 \cdot 5H_2O$, $RhCl_3 \cdot H_2O$, $Rh(NO_3)_2 \cdot 2H_2O$, $Rh_2(SO_4)_3 \cdot 4H_2O$, $Pd(CH_3COO)_2$, $Rh_2(SO_4)_3 \cdot 12H_2O$, $Rh_2(SO_4)_3 \cdot 15H_2O$, $PdCl_2$, $PdCl_2 \cdot 2H_2O$, $PdSO_4$, $PdSO_4 \cdot H_2O$, Pd-$(CH_3COO)_2$, $OsCl_4$, $OsCl_3$, $OsCl_3 \cdot 3H_2O$, $OsI_4$, $IrBr_3 \cdot 4H_2O$, $IrCl_2$, $IrCl_4$, $IrO_2$, $PtBr_4$, $H_2PtCl_6 \cdot 6H_2O$, $PtCl_4$, $PtCl_3$, $Pt(SO_4)_2 \cdot 4H_2O$ oder $Pt(COCl_2)Cl_2$, sowie die entsprechenden Komplexsalze wie $NaAuCl_4$, $(NH_4)_2PdCl_4$, $(NH_4)_2PdCl_6$, $K_2PdCl_6$ oder $KAuCl_4$.

Bevorzugt sind jene Edelmetallsalze, welche als Anion $Cl^-$, $NO_3^-$, $SO_4^{2-}$ oder $CH_3COO^-$ enthalten und gegebenenfalls in hydratisierter Form vorliegen. Besonders bevorzugte Edelmetallsalze sind $PdCl_2$, $PdSO_4$, $PtCl_4$ und $HAuCl_4$

Das erfindungsgemässe Verfahren ist deshalb besonders einfach, weil die zu beschichtenden Kunststoff-Gegenstände lediglich in die wässrige saure Lösung des Edelmetallsalzes ein getaucht werden müssen. Das Aufbringen der wässrigen sauren Lösung kann alternativ durch Aufsprayen, Aufpinseln, roller coating und andere Standardbeschichtungstechniken erfolgen. Die Metallisierung erfolgt unabhängig von der Form des Kunststoff-Gegenstandes an allen Stellen die mit der Lösung in Kontakt kommen. Es hat sich überraschenderweise gezeigt, dass es vorteilhaft ist, die Lösung während des Beschichtungsvorgangs in Bewegung zu halten. Dies erfolgt auf an sich bekannte Weise durch Schütteln oder vorzugsweise durch Rühren, z.B. mittels eines Magnetrührers, durch Bewegen der Probe oder durch Einblasen von Luft. Erstaunlicherweise sinkt der elektrische Widerstand der Metallschicht aus einem bewegten Bad um mehrere Zehnerpotenzen verglichen mit den Produkten aus einem unbewegten Bad. Falls der Kontakt zwischen Kunststoff-Gegenstand und Edelmetallsalz-Lösung während des Beschichtungsvorgangs immer bestehen bleibt, d.h. die Bewegung der Lösung nicht zu heftig durchgeführt wird, ist die Qualität und Haftung der gebildeten Edelmetallschicht ausgezeichnet.

Die Temperatur des Bades ist grundsätzlich nicht kritisch. Vorzugsweise wird die Beschichtung bei etwa 10-95° C durchgeführt, insbesondere bei leicht erhöhter Temperatur, etwa bei 20-45° C.

Die Beschichtung erfolgt in einer sauren Lösung. Der pH hängt dabei auch vom verwendeten Metalloxid-Füllstoff ab. Erfindungsgemäss beträgt der pH der Edelmetallsalz-Lösung bevorzugt 0,5-3,5, besonders bevorzugt 1,5-2,5. Der für die Beschichtung optimale pH-Wert kann für jedes System Metalloxid/Edelmetallsalz mittels weniger Vorversuche ermittelt werden. Es hat sich gezeigt, dass das Optimum jeweils in einem relativ engen pH-Bereich von < 1 pH-Einheit liegt.

Das Einstellen des optimalen pH-Wertes erfolgt auf übliche Weise mittels starker Säuren wie Mineralsäuren, Carbonsäuren oder Sulfonsäuren. Beispiele dafür sind Salzsäure, Salpetersäure, Schwefelsäure, Phosphorsäure, Fluorwasserstoffsäure, Essigsäure oder p-Toluolsulfonsäure. Bevorzugt sind Salzsäure, Salpetersäure und Schwefelsäure. Besonders bevorzugt sind Beschichtungsbäder, in welchen die Säure und das Edelmetallsalz das gleiche Anion besitzen.

Die Beschichtungsdauer hängt natürlich von verschiedenen Parametern ab, wie Temperatur, pH, Konzentration und Bewegung der Beschichtungslösung. Typische kontinuierliche Beschichtungen entstehen üblicherweise in wenigen Minuten.

Für gewisse Anwendungen genügen die so hergestellten Schichtdicken nicht, so dass auf an sich bekannte Weise die Schichtdicke durch elektrochemische, elektrolytische oder elektrochemische plus elektrolytische Metallabscheidung erhöht wird. Bei diesem Schichtaufbau kann via Elektrolyse ein beliebiges Metall aufgebracht werden.

Die so beschichteten Kunststoff-Gegenstände kommen in den verschiedenartigsten Industriezweigen, bei denen man metallische Oberflächen benötigt, zur Anwendung, z.B. in der Automobilindustrie, z.B. für Rahmen von Anzeigeinstrumenten, Radios, Türgriffen, für Fensterheber, Heizungsgrills, Armaturenbrettknöpfe, Scheinwerfer, Rücklichter etc., ferner in der Radio-, TV- und Elektronikindustrie, insbesondere für gedruckte Schaltungen, sowohl in Mehrschicht- wie auch Hybrid-Schaltungen und als Chips-Träger, und in EMI-Shielding Installationen, etc.; ausserdem in der Luftfahrtindustrie, in der Dental- und Medizinalindustrie, in der optischen Industrie, beispielsweise bei der Spiegelherstellung, sowie bei Haushalt-Gegenständen.

Beispiel 1:

Ausgehend von einem Laminierharzgemisch auf Basis von Bisphenol A-diglycidylether mit einem Epoxid-Gehalt von 2,03 Eq/kg, gelöst in Methylethylketon, enthaltend

67,39 Teile Harz

2,37 Teile Härter (Dicyandiamid und 2-Methylimidazol; 10:1)

werden darin 25,16 Teile $Cu_2O$ und 5,09 Teile Antimontrioxid suspendiert. Mit dieser Suspension wird auf üblichem Wege Glasgewebe (Hersteller: Clark-Schwebel) des Typs 7628 (200 g/m$^2$) imprägniert. Diese Prepregs werden getrocknet und in 7 Lagen zu Platten verpresst, deren Zusammensetzung sich wie folgt präsentiert:

| | |
|---|---|
| Harz/Härter | 38,5 Gew.-% |
| Glasgewebe | 45,9 Gew.-% |
| $Sb_2O_3$ | 1,3 Gew.-% |
| $Cu_2O$ | 14,3 Gew.-% |

Mit einem Schmirgelpapier wird die harzreiche Oberfläche aufgerauht. Die so behandelten Platten werden 5 Minuten bei 21° C in eine wässrige Lösung von $PdC1_2$ mit der Konzentration 0,1 g/l getaucht, deren pH-Wert mit Hilfe von HCl auf 2,69 eingestellt ist. Dabei wird das Bad mit einem Magnetrührer (400 U/Min.) gerührt. Der Widerstand zwischen 2 Punktkontakten im Abstand von 8 mm beträgt 40-45 Ohm.

Beispiele 2-7:

Reaktionsbedingungen und Ausgangsmaterial sind analog Beispiel 1, jedoch werden die Rührung des Bades sowie die Badtemperatur variiert.

| Beispiel | Rührung des Bades (U/Min., Magnetrührer) | Temperatur des Bads (°C) | Widerstand (Punktkontakte, 8 mm Abstand) |
|---|---|---|---|
| 2 | keine | 21 | ∞ Ohm |
| 3 | 200 | 21 | 75-90 Ohm |
| 4 | 300 | 21 | 100-110 Ohm |
| 5 | 500 | 21 | 80 Ohm |
| 6 | 400 | 35 | 25-35 Ohm |
| 7 | 400 | 40 | 25 Ohm |

Beispiele 8-9:

Beispiel 1 wird wiederholt, doch wird die Dauer des Eintauchens der Platte in die $PdCl_2$-Lösung variiert.

| Beispiel | Dauer des Eintauchens (Minuten bei 21°C) | Widerstand (Punktkontakte, 8 mm Abstand) |
|---|---|---|
| 8 | 3 | 150-160 Ohm |
| 9 | 4 | 65-70 Ohm |

Beispiele 10-14:

Unter gleichen Bedingungen wie in Beispiel 1 wird die Platte beschichtet, jedoch mit zusätzlichem Schwenken der zu beschichtenden Platte im Bad.

| Beispiel | Rührung des Bades (U/Min., Magnetrührer) | Widerstand (Punktkontakte, 8 mm Abstand) |
|---|---|---|
| 10 | keine | 2000-4000 Ohm |
| 11 | 200 | 75 Ohm |
| 12 | 300 | 75-80 Ohm |
| 13 | 400 | 45 Ohm |
| 14 | 500 | 30 Ohm |

Beispiele 15-21:

Es werden wie in Beispiel 1 Platten beschichtet, jedoch unter Variation des pH-Wertes des Bades durch Zugabe von HCl.

| Beispiel | pH-Wert des Bades | Widerstand, (Punktkontakte, 8 mm Abstand) |
|---|---|---|
| 15 | 3,25 | nicht leitend |
| 16 | 3,05 | 400-460 Ohm |
| 17 | 2,75 | 170-250 Ohm |
| 18 | 2,50 | 80-90 Ohm |
| 19 | 2,40 | 110-120 Ohm |
| 20 | 2,15 | 190-200 Ohm |
| 21 | 2,00 | 700-40'000 Ohm |

Beispiel 22:

Ein Polyamidformteil (Polyamid 66, Typ AP 50 von Rhône-Poulenc) enthaltend 30 Gew.-% $Cu_2O$ wird 20 Min. bei 70°C in einem Entfettungsbad (EC 40-35 von FRAPPAZ-IMASA) behandelt und dann 20 Min. bei Raumtemperatur mit einem Aetzbad (150 ml Kemifar Enplate MLB 497B, 30 ml Kemifar Enplate MLB 497C, 80g Kaliumpermanganat, 40 g Natriumhydroxid, mit Wasser auf 1l aufgefüllt) oberflächlich angeätzt, um die Giesshaut zu entfernen. Das oberflächlich abgeschiedene $MnO_2$ wird durch 2-minütiges Tauchen in 0,1M wässrige Hydrolylaminsulfat-Lösung unter Einfluss von Ultraschall entfernt.Dann wird das Formteil analog Beispiel 1 mit Palladium metallisiert und dieser Metallfilm durch eine elektrolytisch abgeschiedene Kupferschicht mittels einstündigem Eintauchen in ein Galvanobad (KHT 482 von FRAPPAZ-IMASA) beschichtet. Diese Schicht ist 35 Mikron stark.

Beispiel 23:

Ausgehend von einem Polyimid-Formteil (Reaktionsprodukt aus N,N'-4,4'-Diphenyl-methan-bis-maleinimid und Diamino-4,4'-diphenylmethan), das 20 Gew.-% Glas und 40 Gew.-% $Cu_2O$ enthält, wird durch Sandstrahlen ein Relief eines Mäanders von 1,5 m Länge und 0,25 mm Breite eingeätzt.Nach einer Behandlung in verdünnter $HNO_3$ wird die Giesshaut auf dem erhöhten Teil des Reliefs durch Schleifen entfernt. Durch Behandlung mit einer 0,05%-igen wässrigen Lösung von $PdCl_2$ und unter Zufügen von 1 ml HCl (rauchend, p.a.) pro Liter bei Rührung des Bads mit 400 U/Min. (Magnetrührer) und gleichzeitigem Schwenken des Formteils im Bad bei 44°C und 6 Min. Dauer werden leitfähige Strukturen erhalten, die in drei Versuchen Widerstandswerte von 59,7, 59,9 und 57 kOhm aufweisen, die sich nach 24 Tagen um weniger als 2 % absenken. Die nicht angeschliffene Oberfläche wird in diesem Versuch nicht metallisiert.

Beispiel 24:

Unter Verwendung eines Formteils gemäss Beispiel 23 wird unter den im Beispiel 1 angegebenen Bedingungen, jedoch durch Verwendung von 0,3 g/l $HAuCl_4 \cdot aq$ (51,5 Gew.-% Au), 0,6 ml/l HCl (rauchend, p.a.)als Metallsalzbad, in deionisiertem Wasser durch 10-minütiges Tauchen bei 28°C eine Goldschicht abgeschieden, deren Widerstand sich in vier Mustern auf 14,1, 14,5, 14,6 und 14,6 kOhm beläuft. Diese Werte ändern sich innert 25 Tagen um weniger als 10 %. Die nicht angeschliffene Oberfläche wird in diesem Versuch nicht metallisiert.

Beispiele 25-28:

Analog Beispiel 1 werden Platten beschichtet, jedoch unter Verwendung von Hexachloroplatinat als metallisierende Komponente des Bades (0,14 g/l) und unter Variation des pH-Wertes.

| Beispiel | $H_2PtCl_6$ (g/l) | HCl (ml/l) | Widerstand (Punktkontakte, 8 mm Abstand) |
|---|---|---|---|
| 25 | 0,14 | 0,14 | 480 Ohm |
| 26 | 0,14 | 0,28 | 220 Ohm |
| 27 | 0,14 | 0,42 | 580 Ohm |
| 28 | 0,14 | 0,56 | 620 Ohm |

Beispiele 29-47:

Es werden wie in Beispiel 1 Platten beschichtet, jedoch unter Variation der Metallsalze, der Salzkonzentrationen, der Badtemperatur, des pH-Wertes, der Säuren und der Dauer des Eintauchens.

| Beisp. | Salz | Konz. g/l | Badtemp./°C | pH | Eintauchdauer | Widerstand/Ohm |
|--------|------|-----------|-------------|-----|---------------|----------------|
| 29 | HAuCl$_4$ | 0,05 | 20-22 | 2,8 (HCl) | 10 min | 500 |
| 30 | HAuCl$_4$ | 0,1 | 20-22 | 2,5 (HCl) | 10 min | 8 |
| 31 | HAuCl$_4$ | 0,5 | 20-22 | 2,3 (HCl) | 10 min | 6 |
| 32 | HAuCl$_4$ | 1,0 | 20-22 | 2,0 (HCl) | 10 min | 6 |
| 33 | HAuCl$_4$ | 2,5 | 20-22 | 1,4 (HCl) | 10 min | 8,5 |
| 34 | HAuCl$_4$ | 5,0 | 20-22 | 1,1 (HCl) | 10 min | 9,0 |
| 35 | PtCl$_4$ | 5,0 | 20-22 | 2,0 (HCl) | 10 min | 2000 |
| 36 | PtCl$_4$ | 0,5 | 40-45 | 2,0 (HCl) | 10 min | 1400 |
| 37 | PtCl$_4$ | 0,5 | 60-65 | 2,0 (HCl) | 10 min | 140 |
| 38 | Pd(CH$_3$COO)$_2$ | 0,5 | 40-45 | 2,0 (CH$_3$COOH) | 30 min | 50 |
| 39 | Pd(CH$_3$COO)$_2$ | 0,5 | 40-45 | 2,0 (HCl) | 30 min | 25 |
| 40 | PtCl$_4$ | 0,5 | 40-45 | 2,0 (HNO$_3$) | 30 min | 380 |
| 41 | PtCl$_4$ | 0,5 | 40-45 | 2,0 (H$_2$SO$_4$) | 30 min | 380 |
| 42 | PtCl$_4$ | 0,5 | 40-45 | 2,0 (HCl) | 30 min | 325 |
| 43 | HAuCl$_4$ | 0,5 | 40-45 | 2,0 (H$_3$PO$_4$) | 10 min | 25 |
| 44 | PdSO$_4$ | 0,5 | 40-45 | 1,5 (HCl) | 10 min | 20 |
| 45 | PdCl$_2$ | 0,5 | 40-45 | 2,4 (H$_3$PO$_4$) | 10 min | 25 |
| 46 | PdCl$_2$ | 0,5 | 40-45 | 1,7 (HNO$_3$) | 10 min | 25 |
| 47 | PdCl$_2$ | 0,5 | 40-45 | 2,4 (H$_2$SO$_4$) | 10 min | 18 |

Beispiel 48:

Analog zu Beispiel 1 werden Prepregs hergestellt und zu Platten verpresst, deren Oberfläche mit einem Schmirgelpapier aufgerauht wird. Die so behandelten Platten werden 5 Minuten bei 40-45 °C in eine wässrige Lösung von PdCl$_2$ mit der Konzentration von 0,5 g/l getaucht, deren pH-Wert mit HCl auf 2,0 eingestellt ist. Die Lösung wird durch Einblasen von Luft bewegt. Der Widerstand zwischen zwei Punktkontakten im Abstand von 8 mm beträgt 8,5 Ohm.

Beispiel 49:

Ein gemäss Beispiel 1 hergestelltes Epoxidharzformteil wird 5 Minuten bei 60-65 °C in einem Entfettungsbad (Kemifar EC 4035, 10 Vol.%) behandelt. Nach Spülen mit Wasser wird das Muster 15 Minuten in auf 40 °C erwärmtes N-Methylpyrrolidon eingetaucht. Anschliessend wird das Formteil mit Wasser abgespült und 30 Minuten bei 85 °C in einem Aetzbad (150 ml Kemifar Enplate MLB 497B, 30 ml Kemifar Enplate MLB 497C, 80 g Kaliumpermanganat, 40 g Natriumhydroxid, mit Wasser auf 1l aufgefüllt) oberflächlich angeätzt, wobei die Lösung mit einem Magnetrührer gerührt wird (400 U/Min.). Nach Spülen mit Wasser wird das oberflächlich abgeschiedene Mangandioxid durch 6-minütiges Eintauchen in eine 0,1 molare wässrige Hydroxyl aminsulfatlösung unter Einfluss von Ultraschall entfernt. Das Formteil wird wiederum gespült und dann durch Eintauchen in eine wässrige Lösung von PdCl$_2$ (0,1 g/l), metallisiert (6 Min., 44 °C, 1 mll HCL). Dabei wird das Bad mit einem Magnetrührer gerührt (400 U/Min.) Anschliessend wird das Muster mit Wasser gereinigt und der Metallfilm durch Elektrolyse (65 Min., 28 °C, 3 A/dm$^2$) in einem Galvanobad (Kemifar KHT 482) mit Kupfer beschichtet. Während der Elektrolyse wird das Muster bewegt und Luft in die Lösung eingeblasen. Die so erhaltene Kupferschicht hat eine Schichtdicke von 41 Mikron und eine Haftfestigkeit von 13,5 N/cm.

Beispiel 50:

Auf ein Polyurethan-Formteil wird auf einer Seite durch In-Mold-Coating eine Polyurethanschicht enthaltend 30 Gew. % Cu$_2$O aufgetragen. Das Formteil wird 30 Minuten bei 60-65 °C in einem Entfettungsbad (Kemifar EC 4035, 10 Vol.%) behandelt. Nach Spülen mit Wasser wird das Muster 20 Minuten bei Raumtemperatur in einem Aetzbad (150 ml Kemifar Enplate MLB 497B, 30 ml Kemifar Enplate MLB 497C, 80 g Kaliumpermanganat, 40 g Natriumhydroxid, mit Wasser auf 1 l aufgefüllt) oberflächlich angeätzt, wobei die Lösung mit einem Magnetrührer gerührt wird (400 U/Min.). Nach Spülen mit Wasser wird das oberflächlich abgeschiedene Mangandioxid durch 10-minütiges Eintauchen in eine 0,1 molare wässrige Hydroxylaminsulfatlösung unter Einfluss von Ultraschall entfernt. Das Formteil wird wiederum gespült und dann durch Eintauchen in eine wässrige Lösung von $PdCl_2$ (0,5 g/l), metallisiert (6 Min., 40-45 °C, 1 ml HCl, pH = 1,9). Dabei wird das Bad mit einem Magnetrührer gerührt (400 U/Min.) Anschliessend wird das Muster mit Wasser gereinigt und der Metallfilm durch Elektrolyse (65 Min., 28 °C, 3 A/dm$^2$) in einem Galvanobad (Kemifar KHT 482) mit Kupfer beschichtet. Während der Elektrolyse wird das Muster bewegt und Luft in die Lösung eingeblasen. Die so erhaltene Kupferschicht hat eine Schichtdicke von 41 Mikron. Die Haftfestigkeit ist grösser als 6 N/cm. Die Seite des Formteils, die kein $Cu_2O$ enthält, wird nicht metallisiert.

Beispiel 51:

Ein Polytetrafluorethylen-Formteil enthaltend 15 Gew.% $Cu_2O$ wird wie in Beispiel 1 mit Schmirgelpapier vorbehandelt. Das Muster wird dann 5 Minuten bei 21 °C in eine wässrige Lösung von $PdCl_2$ mit der Konzentration 0,5 g/l getaucht, deren pH-Wert mit Hilfe von HCl auf 2,2 eingestellt ist. Dabei wird das Bad mit einem Magnetrührer (400 U/Min.) gerührt. Der Widerstand zwischen 2 Punktkontakten im Abstand von 8 mm beträgt 30 Ohm.
Anschliessend wird der Metallfilm wie in Beispiel 49 und 50 elektrolytisch mit Kupfer beschichtet. Die Schichtdicke des so abgeschiedenen Kupfers beträgt 10 Mikron.

Beispiel 52:

Ein gemäss Beispiel 1 hergestelltes Epoxidharzformteil wird 5 Minuten bei 40-45 °C in eine wässrige Lösung von $PdCl_2$ mit der Konzentration 0,5 g/l getaucht, deren pH-Wert mit Hilfe von HCl auf 2,0 eingestellt ist. Dabei wird das Bad mit einem Magnetrührer (400 U/Min.) gerührt. Der Widerstand zwischen 2 Punktkontakten im Abstand von 8 mm beträgt 9 Ohm.

**Ansprüche**

1. Verfahren zum Beschichten eines Kunststoff-Gegenstandes mit einer dünnen Edelmetallschicht, dadurch gekennzeichnet, dass der Kunststoff-Gegenstand einen feinteiligen, homogen verteilten Füllstoff ausgewählt aus der Gruppe bestehend aus MnO, NiO, $Cu_2O$, SnO und $Bi_2O_3$ enthält und dieser Kunststoff-Gegenstand mit einer sauren wässrigen Lösung eines Edelmetallsalzes behandelt wird.

2. Verfahren gemäss Anspruch 1, wobei der Kunststoff-Gegenstand aus 2,5-90 Gew.-% des Füllstoffs und 97,5-10 Gew.-% eines polymeren Harzes besteht.

3. Verfahren gemäss Anspruch 2, wobei der Kunststoff-Gegenstand aus 10-30 Gew.-% des Füllstoffs und 90-70 Gew.-% eines polymeren Harzes besteht.

4. Verfahren gemäss Anspruch 1, wobei 1 Liter der wässrigen Lösung mindestens $10^{-5}$ Mol eines Edelmetallsalzes enthält.

5. Verfahren gemäss Anspruch 1, wobei das Edelmetallsalz ein Salz von Au, Ag, Ru, Rh, Pd, Os, Ir oder Pt ist.

6. Verfahren gemäss Anspruch 5, wobei das Edelmetallsalz als Anion $Cl^-$, $NO_3^-$, $SO_4^{2-}$ oder $CH_3COO^-$ enthält.

7. Verfahren gemäss Anspruch 1, wobei der Kunststoff-Gegenstand in eine saure, wässrige Lösung eines Edelmetallsalzes eingetaucht wird oder die Beschichtung mittels einer Standardbeschichtungstechnologie (Sprayen, Roller Coating, Aufpinseln) aufgebracht wird.

8. Verfahren gemäss Anspruch 7, wobei die wässrige Lösung in Bewegung gehalten wird.

9. Verfahren gemäss Anspruch 8, wobei die Lösung gerührt wird.

10. Verfahren gemäss Anspruch 7, wobei die Lösung eine Temperatur von 10-95 °C besitzt.

11. Verfahren gemäss Anspruch 10, wobei die Lösung eine Temperatur von 20-45 °C besitzt.

12. Verfahren gemäss Anspruch 1, wobei der pH der sauren wässrigen Lösung 0,5 bis 3,5, bevorzugt 1,5 bis 2,5, beträgt.

13. Verfahren gemäss Anspruch 1, wobei nach dem Beschichten des Kunststoff-Gegenstandes die Schichtdicke durch elektrochemische, elektrolytische oder elektrochemische plus elektrolytische Metallabscheidung erhöht wird.

14. Der nach einem der Verfahren gemäss Anspruch 1 oder Anspruch 13 erhältliche Kunststoff-Gegenstand.